# EUROPEAN PATENT APPLICATION

(11) **EP 4 514 080 A1**
(43) Date of publication of application: **26.02.2025**
(21) Application number: 23795297.3
(22) Date of filing: 23.04.2023
(51) Int. Cl.: H05K 7/20, G06F 1/20

(54) **FLEXIBLE FLUID-COOLING HEAT DISSIPATION UNIT**

(30) Priority: 26.04.2022 CN 202210457090
(71) Applicant: Huawei Technologies Co., Ltd., Shenzhen, Guangdong 518129 (CN)
(72) Inventor: LI, Min, Shenzhen, Guangdong 518129 (CN); WANG, Guangjing, Shenzhen, Guangdong 518129 (CN); BAI, Lu, Shenzhen, Guangdong 518129 (CN); YU, Fei, Shenzhen, Guangdong 518129 (CN)
(74) Representative: Gill Jennings & Every LLP
(86) International application number: PCT/CN2023/090139
(87) International publication number: WO 2023/207864

(57) **Abstract**

This application provides a flexible liquid cooling heat dissipation unit. The flexible liquid cooling heat dissipation unit is configured to dissipate heat for a heat generation component. A liquid inlet and a liquid outlet are provided on the flexible liquid cooling heat dissipation unit. A heat exchange cavity that is used for accommodating a coolant and allowing the coolant to flow from the liquid inlet to the liquid outlet is provided in the flexible liquid cooling heat dissipation unit. The liquid cooling heat dissipation unit includes a flexible sheet material. The flexible sheet material is obtained by compounding a plurality of functional film layers, the plurality of functional film layers include at least one anti-penetration layer, and permeability of the anti-penetration layer is less than 1 g/m²/24hr. The flexible liquid cooling heat dissipation unit provided in this application has better blocking performance, can prevent the internal coolant from leaking out to the outside, avoid damage to another component inside a liquid cooling heat dissipation apparatus, ensure that the heat dissipation apparatus can run stably for a long time, and prolong a service life of the heat dissipation apparatus.

## Description

This application claims priority to Chinese Patent Application No. 202210457090.1, filed with the China National Intellectual Property Administration on April 26, 2022 and entitled "FLEXIBLE LIQUID COOLING HEAT DISSIPATION UNIT", which is incorporated herein by reference in its entirety.

### TECHNICAL FIELD

This application relates to the field of heat dissipation technologies, and in particular, to a flexible liquid cooling heat dissipation unit and a liquid cooling heat dissipation apparatus including the flexible liquid cooling heat dissipation unit.

### BACKGROUND

To process a rapidly increasing amount of information, a server needs to continuously improve computing performance of the server, and needs more components with higher computing speeds, which causes a rapid increase in heat generated by a system. In addition, because a volume of the server is limited and a component layout is compact, a heat consumption density of the system increases sharply. Currently, system heat dissipation becomes a maj or bottleneck restricting server performance improvement. A conventional air cooling mode is inadequate to resolve this problem. Liquid cooling is favored by many enterprises due to excellent heat dissipation performance of the liquid cooling, and the liquid cooling is about to be a main heat dissipation mode of the server.

As a key component of the server, a memory contributes more than 50% of the heat. A working temperature of the memory is inversely proportional to performance. Therefore, effective heat dissipation is critical to the memory. A common memory liquid cooling implementation in the market is to form heat contact between a radiator of a liquid cooling module and a memory chip, and dissipate heat into an environment by using a coolant flowing in the radiator.

A related technology discloses a liquid cooling heat dissipation mode. In the liquid cooling heat dissipation mode, a flexible water bag is used as a radiator to be in contact with the memory chip, so that full contact with the memory chip can be implemented, to enhance heat dissipation. For the foregoing heat dissipation structure, the flexible water bag is made of a flexible material, and the flexible material has a problem of liquid penetration. During long-term use, in a pressurized working state, a coolant in the flexible water bag penetrates through the flexible material to reach an interface between the water bag and the memory chip, and even further immerses into a package body of a chip, or aggregates at a wrinkle to form a small droplet. This brings a long-term reliability risk.

### SUMMARY

This application provides a flexible liquid cooling heat dissipation unit with better blocking performance, to prevent an internal coolant from leaking out to the outside, avoid damage to another component inside a liquid cooling heat dissipation apparatus, ensure that the heat dissipation apparatus can run stably for a long time, and prolong a service life of the heat dissipation apparatus.

According to a first aspect, this application provides a flexible liquid cooling heat dissipation unit. The flexible liquid cooling heat dissipation unit is configured to dissipate heat for a heat generation component. A liquid inlet and a liquid outlet are provided on the flexible liquid cooling heat dissipation unit. A heat exchange cavity that is used for accommodating a coolant and allowing the coolant to flow from the liquid inlet to the liquid outlet is provided in the flexible liquid cooling heat dissipation unit. The liquid cooling heat dissipation unit includes a flexible sheet material. The flexible sheet material is obtained by compounding a plurality of functional film layers, the plurality of functional film layers include at least one anti-penetration layer, and permeability of the anti-penetration layer is less than 1 g/m2/24hr.

The flexible sheet material of the flexible heat dissipation unit provided in this embodiment of this application needs to meet all of requirements of high strength, high thermal conductivity, low water vapor permeability, and the like, which is difficult to be implemented by using a single layer of film. Therefore, the flexible sheet material uses a composite film material made of a plurality of film materials. For a flexible sheet material including a single film layer, this application can reduce difficulty in designing and selecting the flexible sheet material, and help ensure that the flexible sheet material has appropriate strength, stiffness, flexibility, better thermal conductivity, and better isolation. In this application, the flexible sheet material may be obtained by randomly compounding a plurality of layers (for example, three to five layers) of same or different functional film layers, to meet design requirements of the foregoing aspects.

The plurality of functional film layers include at least one anti-penetration layer. The anti-penetration layer is specifically made of a material with low permeability (less than 1 g/m²/24hr). Combined with common blocking effect of the plurality of film layers obtained after composite, the heat dissipation unit provided in this embodiment of this application has better blocking performance. In an entire life cycle (for example, 10 years), the internal coolant (for example, water) can be effectively prevented from leaking out, and use reliability of the heat dissipation unit is improved. This avoids damage to another component in a heat dissipation apparatus in which the heat dissipation unit is used, ensures that the heat dissipation apparatus can run stably for a long time, and helps prolong a service life of the heat dissipation apparatus.

The heat dissipation unit provided in this embodiment of this application and a liquid cooling pipeline can form a closed circulation system, to continuously take away, through liquid circulation, heat generated by a chip when the heat generation component works. Compared with a conventional metal radiator, the heat dissipation unit can be in close contact with the heat generation component (reduce a contact thermal resistance), and a contact area is larger, thereby having higher heat dissipation efficiency.

For a case in which the conventional metal radiator is directly fastened on the heat generation component, the metal radiator must be removed when the heat generation component is maintained, which is inconvenient to operate and has a risk of a coolant leakage. In addition, because a size of the metal radiator is large, it is also not conducive to disposing heat generation components more closely on a circuit board. However, the heat dissipation unit provided in this embodiment of this application can shrink in a non-working state without pressure. In this case, the heat dissipation unit may be automatically separated from the heat generation component, so that operations such as plugging and unplugging and maintenance can be conveniently performed on the heat generation component, a coolant leakage problem is avoided, the heat generation components may be disposed more closely, and an installation spacing between the heat generation components may be further reduced, for example, to 7.6 mm or even to a smaller spacing. An overall structure is easier to install and maintain, and is more cost-effective.

Optionally, the flexible sheet material may have one or more anti-penetration layers. When there are a plurality of anti-penetration layers (for example, two or three layers), the plurality of anti-penetration layers may be sequentially stacked, and two adjacent anti-penetration layers may be directly attached to each other, or there may be at least one other functional film layer in a middle of the two anti-penetration layers.

In a possible design, the plurality of functional film layers further include a protective layer and a heat sealing layer, the anti-penetration layer is located between the protective layer and the heat sealing layer, and the protective layer forms an outer surface of the flexible liquid cooling heat dissipation unit.

The foregoing three film layers may be bonded and composited by using a thermal adhesive, a pressure-sensitive adhesive, or the like. The protective layer may be used as a flexible base material to ensure that the flexible sheet material has sufficient strength. The protective layer is disposed on an outer layer, so that it can be avoided that a liquid leakage problem occurs because the flexible sheet material is punctured by an external sharp component. In addition, the heat sealing layer is disposed inside the penetration layer, so that two flexible sheet materials can be conveniently sealed and interconnected in a heat sealing manner, to construct a heat dissipation unit with a bag structure, and ensure that the heat dissipation unit has sufficient sealing performance to prevent a liquid leakage problem.

In a possible design, the plurality of functional film layers further include a structure enhancing layer, and the structure enhancing layer is located between the protective layer and the heat sealing layer.

In a possible design, the anti-penetration layer includes at least one of the following film layers: an ethylene vinyl alcohol copolymer film layer, a polyvinylidene chloride film layer, an o-phenylphenol film layer, an aluminum-cast polypropylene film layer, a polyethylene film layer, a polyethylene glycol terephthalate film layer, a cast polypropylene film layer, a linear low-density polyethylene film layer, a cellulose propionate film layer, a polyamide film layer, or a metal film layer.

Optionally, the anti-penetration layer may be a metal layer. The metal layer has better anti-penetration performance, and also has good temperature uniformity and thermal conductivity, so that the flexible sheet material can meet all of requirements of high strength, high thermal conductivity, low water vapor permeability, and the like, thereby improving heat dissipation efficiency and use reliability of the heat dissipation unit.

In a possible design, the anti-penetration layer may be a metal foil layer or a metal vapor deposition layer. For example, the metal foil layer may be a copper foil or an aluminum foil. The metal vapor deposition layer may form a metal film layer such as aluminum or copper on an inner surface of the protective layer or an outer surface of the heat sealing layer through vacuum vapor deposition, sputtering coating, arc plasma coating, or the like.

Optionally, on a basis of selecting the foregoing material, a thickness of the anti-penetration layer may range between 8 µm and 15 µm (micrometers), for example, may be 9 µm, 10 µm, 11 µm, 12 µm, or 14 µm.

Optionally, the permeability of the anti-penetration layer may range between 0.5 g/m²/24hr and 1 g/m²/24hr, for example, may be 0.6 g/m²/24hr, 0.7 g/m²/24hr, 0.8 g/m²/24hr, or 0.9 g/m²/24hr.

In a possible design, the heat sealing layer includes at least one of the following film layers: a low-density polyethylene film layer, a linear low-density polyethylene film layer, an ethylene-vinyl acetate copolymer layer, a high-density polyethylene film layer, or a polypropylene film layer.

In a possible design, the protective layer includes at least one of the following film layers: a polyethylene glycol terephthalate film layer, a linear low-density polyethylene film layer, a polyethylene layer, a polyamide film layer, a cast polypropylene film layer, or a thermoplastic polyurethane film layer.

In a possible design, the liquid cooling heat dissipation unit has a hollow bag structure obtained by sealing and interconnecting two flexible sheet materials.

Optionally, surrounding edges of the two flexible sheet materials may be sealed and connected by using a high-frequency hot-pressing welding process, an ultrasonic hot-pressing (welding) process, and the like.

In a possible design, the flexible liquid cooling heat dissipation unit further includes a mounting ear disposed on the flexible sheet material, and a through hole is provided inside the mounting ear.

The mounting ear has a hollow structure and has the through hole inside. During actual application, a component such as a support beam (pole) may be penetrated into the through hole to "hang" the heat dissipation unit, to implement installation and positioning of the mounting ear. There may be a plurality of heat dissipation units in an entire liquid cooling cycle. In this case, one support beam may simultaneously pass through through holes of mounting ears of the plurality of heat dissipation units that are disposed in parallel, thereby helping simplify an installation structure.

Optionally, the heat dissipation unit may have one or more mounting ears based on a size, a shape, and the like of the heat dissipation unit. For example, two, three, or four mounting ears may be disposed. The plurality of mounting ears may be disposed at different positions of the heat dissipation unit at spacings. For example, the plurality of mounting ears are disposed at two opposite ends of the heat dissipation unit, at least one mounting ear is disposed adjacent to the liquid inlet, and at least one mounting ear is disposed adjacent to the liquid outlet.

Optionally, the mounting ear may be disposed on the flexible sheet material in a manner such as bonding. Alternatively, the mounting ear and the flexible sheet material may be cut from a same sheet material to form an integrated structure, and the mounting ear protrudes from an edge of the flexible sheet material.

In a possible design, the flexible liquid cooling heat dissipation unit further includes flow guiding hoses disposed on the liquid inlet and the liquid outlet.

The flow guiding hose is disposed, so that sealing and interconnection between the heat dissipation unit and an external pipeline can be facilitated, and installation and disposing of the heat dissipation unit are also facilitated. In addition, a liquid leakage problem caused by a direct connection between the external pipeline and the liquid inlet or outlet can also be avoided.

In a possible design, the heat generation component is a memory module, and the flexible liquid cooling heat dissipation unit is configured to be disposed between two memory modules.

In this case, two side surfaces of the flexible liquid cooling heat dissipation unit may be in direct or indirect contact with surfaces of the two memory modules on two sides, and heat of the memory module may be conducted to the coolant in the flexible liquid cooling heat dissipation unit. The coolant takes away the heat, to perform heat dissipation and cooling on the memory module.

According to a second aspect, a liquid cooling heat dissipation apparatus is provided, including: a heat generation component; and the flexible liquid cooling heat dissipation unit provided in any one of the possible designs of the first aspect. The liquid cooling heat dissipation unit is configured to: be in contact with the heat generation component, and dissipate heat for the heat generation component by using a coolant flowing in the heat exchange cavity.

In a possible design, the liquid cooling heat dissipation apparatus further includes: a circuit board, where a plurality of heat generation components are disposed on the circuit board; a circulation pipeline, configured to interconnect a plurality of liquid cooling heat dissipation units in parallel and/or in series, where the plurality of liquid cooling heat dissipation units dissipate heat for the plurality of heat generation components; and a pipeline interface, configured to be connected to an external pipeline, to transfer a coolant to the circulation pipeline, and discharge, from the circulation pipeline, a coolant obtained after heat exchange.

In a possible design, the heat generation component is a memory module, and the flexible liquid cooling heat dissipation unit is disposed between two memory modules.

Because the heat dissipation apparatus uses the flexible liquid cooling heat dissipation unit provided in any one of the possible designs of the first aspect, the heat dissipation apparatus also has technical effect corresponding to the heat dissipation unit. Details are not described herein again.

According to a third aspect, this application provides an electronic device, including the liquid cooling heat dissipation apparatus in the second aspect. The electronic device may be a server or a device with functions such as computing and communication.

### BRIEF DESCRIPTION OF DRAWINGS

FIG. 1 is a diagram of an overall structure of an example of a flexible liquid cooling heat dissipation unit according to an embodiment of this application;
FIG. 2 is an application diagram of the flexible liquid cooling heat dissipation unit shown in FIG. 1;
FIG. 3 is a cross-sectional view from an AA perspective in FIG. 1;
FIG. 4 is a cross-sectional view of another example of a flexible sheet material;
FIG. 5 is a diagram of an overall structure of another example of a flexible liquid cooling heat dissipation unit according to an embodiment of this application;
FIG. 6 is a diagram of an overall structure of still another example of a flexible liquid cooling heat dissipation unit according to an embodiment of this application;
FIG. 7 is a diagram of an overall structure of yet another example of a flexible liquid cooling heat dissipation unit according to an embodiment of this application;
FIG. 8 is a diagram of an overall structure of an example of a liquid cooling heat dissipation apparatus according to an embodiment of this application;
FIG. 9 is a cross-sectional view from a BB perspective in FIG. 8;
FIG. 10 is a diagram of an overall structure of another example of a liquid cooling heat dissipation apparatus according to an embodiment of this application;
FIG. 11 is a distribution diagram of test points existing when the liquid cooling heat dissipation apparatus shown in FIG. 10 is tested;
FIG. 12 is a temperature distribution diagram of each test point shown in FIG. 11;
FIG. 13 is an exploded diagram of a structure of a cabinet-type server according to an embodiment of this application;
FIG. 14 is a diagram of an overall structure of an example of a liquid cooling heat dissipation apparatus in FIG. 13;
FIG. 15 is a diagram of an overall structure of another example of a liquid cooling heat dissipation apparatus in FIG. 13;
FIG. 16 is a diagram of an overall structure of a liquid circulation system in FIG. 13; and
FIG. 17 is a diagram of installation of a liquid circulation system.

Reference numerals:
10: flexible liquid cooling heat dissipation unit; 11: liquid inlet; 12: liquid outlet; 13: heat exchange cavity; 14: flexible sheet material; 141: protective layer; 142: anti-penetration layer; 143: heat sealing layer; 144: structure enhancing layer; 15: mounting ear; 16: flow guiding hose; 17: concave space;
20: heat generation component; 21: substrate; 22: memory chip; 23: power supply chip; 24: gold finger;
30: circuit board; 31: socket; 32: main chip;
40: circulation pipeline;
50: pipeline interface;
60: limiting structure; 61: limiting plate; 62: crossbeam;
70: liquid distributor;
80: liquid collector;
90: liquid distributor;
100: liquid cooling heat dissipation apparatus; 101: cabinet water inlet pipe; 102: liquid distribution pipe; 103: node liquid inlet pipe; 104: node liquid outlet pipe; 105: liquid collection pipe; 106: cabinet water outlet pipe; 110: liquid cooling plate;
200: cabinet;
300: liquid circulation system; 310: heat exchanger; 320: external circulation water pipe; 330: liquid cooling pump; 340: solenoid valve;
400: battery subrack;
601-603/605-611: memory chip; 604: power supply chip.

### DESCRIPTION OF EMBODIMENTS

The following describes implementations of this application in detail. Examples of the implementations are shown in the accompanying drawings. Same or similar reference signs always indicate same or similar elements or elements with same or similar functions. The implementations described below with reference to the accompanying drawings are examples, and are merely used to explain this application, and shall not be understood as a limitation on this application.

In the descriptions of this application, it should be noted that, unless otherwise specified and limited, terms "mount" and "connect" should be understood in a broad sense. For example, the terms may indicate a fixed connection, a detachable connection, or an integrated connection, may indicate a mechanical connection, an electrical connection, or mutual communication, or may indicate a direct interconnection, an indirect interconnection through an intermediate medium, internal communication between two elements, or an interaction relationship between two elements. A person of ordinary skill in the art may understand specific meanings of the foregoing terms in this application based on specific cases.

In the description of this application, it should be understood that orientation or position relationships indicated by terms "above", "below", "side", "front", "rear", and the like are based on orientation or position relationships of mounting, and are merely intended for ease of describing this application and simplifying the descriptions, but are not intended to indicate or imply that a specified apparatus or element needs to have a specific orientation or be constructed and operated in a specific orientation. Therefore, this cannot be understood as a limitation on this application.

It should be further noted that in embodiments of this application, a same reference numeral indicates a same component or a same part. For a same part in embodiments of this application, only one part or component may be used as an example to mark a reference numeral in the figure. It should be understood that, for another same part or component, reference numerals are also applicable.

To facilitate understanding of embodiments of this application, related technical terms in embodiments are first explained as follows in this specification.

Node: In a communication network, a node may be an open or private telephone exchange, remote hub, or computer, and provide some intelligent network services. In this specification, the node may be a subrack-type computer module of a cabinet-type computing device.

Memory: The memory is also referred to as an internal memory and a main memory, and is used to temporarily store operation data in the central processing unit (central processing unit, CPU) and data exchanged with an external memory such as a hard disk. A physical form of the memory usually exists in a form of pluggable memory module. In addition to a memory chip, a gold finger interface connected to a mainboard is further disposed on the memory module. A capacity of a single memory module is usually set to 4 G, 8 G, or 16 G.

As two key components of a computer device, the CPU and the memory generate more than 80% of total power consumption of a computer, and are key objects that need heat dissipation. CPUs are usually arranged in a flat manner along the mainboard, and power consumption of the CPUs is centralized. Memories are usually arranged in an array manner perpendicular to the mainboard, a quantity of cards is large, and power consumption of the memories is distributed.

Memory chip: The memory chip is a chip on a memory module, is a core component of the memory module, and is also a heat source on the memory module and a component that needs heat dissipation. A plurality of memory chips are usually disposed on one memory module.

Liquid cooling: The liquid cooling means that liquid is used to replace air, and is forcibly circulated, under driving of a pump, to take away heat generated by a CPU, a memory module, a chipset, an expansion card, and another component during running. A refrigerant used in the liquid cooling usually includes water, mineral oil, electronic fluoride liquid, and the like. The liquid cooling includes two typical modes: cold plate liquid cooling (indirect cooling) and immersion liquid cooling (direct cooling). This application mainly relates to the cold plate liquid cooling. Heat dissipation performance of a liquid cooling heat dissipation apparatus is directly proportional to a flow rate of a coolant (water or other liquid) in the liquid cooling heat dissipation apparatus. Compared with an air cooling heat dissipation apparatus, the liquid cooling heat dissipation apparatus has advantages such as quietness, stable cooling, and less dependence on an environment.

Permeability: A phenomenon that gas or water vapor moves from a high-concentration region to a low-concentration region through a film packaging material. The permeability is an important parameter for evaluating performance of the packaging material. The permeability is generally a weight of gas or water vapor passing through a film per unit area per day at a constant temperature and a unit pressure difference, and a unit is g/m²/24hr (gram/square meter/24 hours).

Embodiments of this application provide a flexible liquid cooling heat dissipation unit and a liquid cooling heat dissipation apparatus with the flexible liquid cooling heat dissipation unit. The flexible liquid cooling heat dissipation unit has better blocking performance, can prevent an internal coolant from leaking out to the outside, avoid damage to another component inside the liquid cooling heat dissipation apparatus, ensure that the heat dissipation apparatus can run stably for a long time, and prolong a service life of the heat dissipation apparatus.

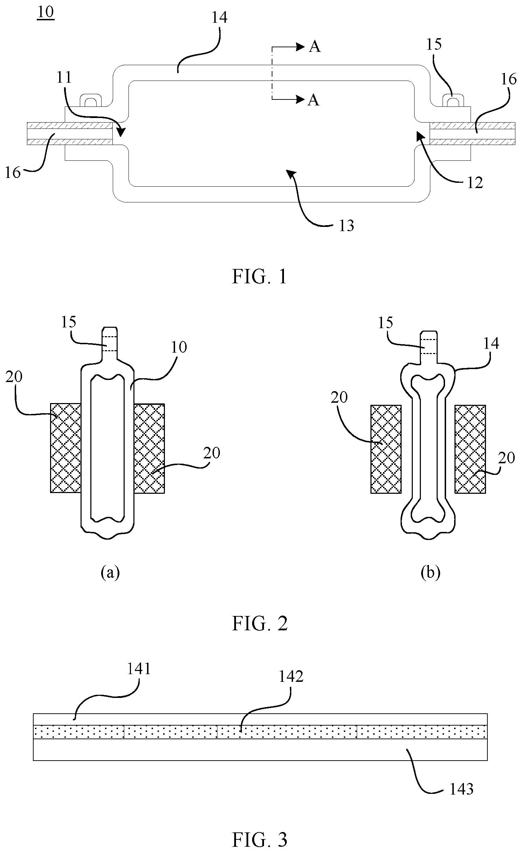

FIG. 1 is a diagram of an overall structure of an example of a flexible liquid cooling heat dissipation unit 10 according to an embodiment of this application. FIG. 2 is an application diagram of the flexible liquid cooling heat dissipation unit 10 shown in FIG. 1. As shown in FIG. 1 and FIG. 2, the flexible liquid cooling heat dissipation unit 10 (referred to as a heat dissipation unit 10 below) provided in this embodiment of this application is configured to dissipate heat for a heat generation component 20. A liquid inlet 11 and a liquid outlet 12 are provided on the heat dissipation unit 10, and the liquid inlet 11 and the liquid outlet 12 are located on two opposite sides of the heat dissipation unit 10. A heat exchange cavity 13 that is used for accommodating a coolant and allowing the coolant to flow from the liquid inlet 11 to the liquid outlet 12 is provided in the heat dissipation unit 10.

The heat dissipation unit 10 is made of a flexible material, and can be deformed to some extent. The heat dissipation unit 10 may be a part of a sealed liquid cooling cycle system. When the sealed liquid cooling cycle system works, the coolant enters the heat exchange cavity 13 inside the heat dissipation unit 10 from the liquid inlet 11, and the heat dissipation unit 10 is expanded, deformed and bulged under an action of internal positive pressure. As shown in part (a) in FIG. 2, the heat dissipation unit 10 is expanded due to the coolant stored in the heat dissipation unit 10, so that an outer wall of the heat dissipation unit 10 can be closely attached to (in contact with) the heat generation component 20. The heat dissipation unit 10 is thermally conductively connected to the heat generation component 20. After absorbing heat dissipated by the heat generation component 20, an internal heat exchange medium flows from the liquid outlet 12 to the outside, and takes away the heat dissipated by the heat generation component 20, to dissipate the heat to an external environment. In this way, heat dissipation is performed on the heat generation component 20.

As shown in part (b) in FIG. 2, when the heat generation component 20 does not need heat dissipation, the sealed liquid cooling cycle system may stop working. In this case, when the heat dissipation unit 10 is in a non-working state without pressure, the heat dissipation unit 10 shrinks and a volume of the heat dissipation unit 10 is reduced, the heat dissipation unit 10 is separated from the heat generation component 20, and a gap is generated between the heat dissipation unit 10 and the heat generation component 20. For example, the heat generation component 20 may be any component that can generate heat during working, for example, a memory module (memory chip), a power supply chip, or a CPU. However, this is not limited thereto.

FIG. 3 is a cross-sectional view from an AA perspective in FIG. 1. As shown in FIG. 1 to FIG. 3, the heat dissipation unit 10 includes a flexible sheet material 14, the flexible sheet material 14 is obtained by compounding and pressing a plurality of functional film layers, the plurality of functional film layers include at least one anti-penetration layer 142, and permeability of the anti-penetration layer 142 is less than 1 g/m²/24hr (gram/square meter/24 hours).

The flexible sheet material 14 of the flexible heat dissipation unit 10 provided in this embodiment of this application needs to meet all of requirements of high strength, high thermal conductivity, low water vapor permeability, and the like, which is difficult to be implemented by using a single layer of film. Therefore, the flexible sheet material 14 uses a composite film material made of a plurality of film materials. For a flexible sheet material 14 including a single film layer, this application can reduce difficulty in designing and selecting the flexible sheet material 14, and help ensure that the flexible sheet material 14 has appropriate strength, stiffness, flexibility, better thermal conductivity, and better isolation. In this application, the flexible sheet material 14 may be obtained by randomly compounding a plurality of layers (for example, three to five layers) of same or different functional film layers, to meet design requirements of the foregoing aspects.

The plurality of functional film layers include at least one anti-penetration layer 142. The anti-penetration layer 142 is specifically made of a material with low permeability (less than 1 g/m²/24hr). Combined with common blocking effect of the plurality of film layers obtained after composite, the heat dissipation unit 10 provided in this embodiment of this application has better blocking performance. In an entire life cycle (for example, 10 years), the internal coolant (for example, water) can be effectively prevented from leaking out, and use reliability of the heat dissipation unit 10 is improved. This avoids damage to another component in a heat dissipation apparatus in which the heat dissipation unit 10 is used, ensures that the heat dissipation apparatus can run stably for a long time, and helps prolong a service life of the heat dissipation apparatus.

The heat dissipation unit 10 provided in this embodiment of this application and a liquid cooling pipeline can form a closed circulation system, to continuously take away, through liquid circulation, heat generated by a chip when the heat generation component 20 works. Compared with a conventional metal radiator, the heat dissipation unit 10 can be in close contact with the heat generation component 20 (reduce a contact thermal resistance), and a contact area is larger, thereby having higher heat dissipation efficiency.

For a case in which the conventional metal radiator is directly fastened on the heat generation component 20, the metal radiator must be removed when the heat generation component 20 is maintained, which is inconvenient to operate and has a risk of a coolant leakage. In addition, because a size of the metal radiator is large, it is also not conducive to disposing heat generation components 20 more closely on a circuit board. However, the heat dissipation unit 10 provided in this embodiment of this application can shrink in a non-working state without pressure. In this case, the heat dissipation unit 10 may be automatically separated from the heat generation component 20, so that operations such as plugging and unplugging and maintenance can be conveniently performed on the heat generation component 20, a coolant leakage problem is avoided, the heat generation components 20 may be disposed more closely, and an installation spacing between the heat generation components 20 may be further reduced, for example, to 7.6 mm or even to a smaller spacing. An overall structure is easier to install and maintain, and is more cost-effective.

Optionally, the flexible sheet material 14 may have one or more anti-penetration layers 142. When there are a plurality of anti-penetration layers 142 (for example, two or three layers), the plurality of anti-penetration layers 142 may be sequentially stacked, and two adjacent anti-penetration layers 142 may be directly attached to each other, or there may be at least one other functional film layer in a middle of the two anti-penetration layers.

In addition to having sufficient anti-penetration performance, the anti-penetration layer 142 should further have appropriate flexibility and thermal conductivity, to ensure that the heat dissipation unit 10 can have sufficient deformation and a strong heat conduction capability. The inventor of this application determines, through a large quantity of creative efforts, that the anti-penetration layer 142 may include at least one of the following film layers:
an ethylene vinyl alcohol copolymer (ethylene vinyl alcohol copolymer, EVOH) film layer, a polyvinylidene chloride (poly (vinylidene chloride), PVDC) film layer, an o-phenylphenol (O-phenylphenol, OPP) film layer, an aluminum-cast polypropylene (ALVM-cast polypropylene, ALVM-CPP) film layer, a polyethylene (polyethylene, PE) film layer, a polyethylene glycol terephthalate (polyethylene glycol terephthalate, PET) film layer, a cast polypropylene (cast polypropylene, CPP) film layer, a linear low-density polyethylene (linear low-density polyethylene, LLDPE) film layer, a cellulose propionate (cellulose propionate, CP) film layer, a polyamide (Nylon, ONY) film layer (namely, a nylon film), a metal film layer, or the like.

In a possible implementation, the anti-penetration layer 142 may be a metal layer. The metal layer has better anti-penetration performance, and also has good temperature uniformity and thermal conductivity, so that the flexible sheet material 14 can meet all of requirements of high strength, high thermal conductivity, low water vapor permeability, and the like, thereby improving heat dissipation efficiency and use reliability of the heat dissipation unit 10.

Optionally, the anti-penetration layer 142 may be a metal foil layer or a metal vapor deposition layer. For example, the metal foil layer may be a copper foil or an aluminum foil. The metal vapor deposition layer may form a metal film layer such as aluminum or copper on an inner surface of a protective layer 141 or an outer surface of a heat sealing layer 143 through vacuum vapor deposition, sputtering coating, arc plasma coating, or the like.

Optionally, on a basis of selecting the foregoing material, a thickness of the anti-penetration layer 142 may range between 8 µm and 15 µm (micrometers), for example, may be 9 µm, 10 µm, 11 µm, 12 µm, or 14 µm.

Optionally, the permeability of the anti-penetration layer 142 may range between 0.5 g/m²/24hr and 1 g/m²/24hr, for example, may be 0.6 g/m²/24hr, 0.7 g/m²/24hr, 0.8 g/m²/24hr, or 0.9 g/m²/24hr.

As shown in FIG. 3, the plurality of functional film layers that form the flexible sheet material 14 further include the protective layer 141 and the heat sealing layer 143. The anti-penetration layer 142 is located between the protective layer 141 and the heat sealing layer 143. The protective layer 141 forms an outer surface of the flexible liquid cooling heat dissipation unit 10. The foregoing three film layers may be bonded and composited by using a thermal adhesive, a pressure-sensitive adhesive, or the like. The protective layer 141 may be used as a flexible base material to ensure that the flexible sheet material 14 has sufficient strength. The protective layer 141 is disposed on an outer layer, so that it can be avoided that a liquid leakage problem occurs because the flexible sheet material 14 is punctured by an external sharp component. In addition, the heat sealing layer 143 is disposed inside the penetration layer 142, so that two flexible sheet materials 14 can be conveniently sealed and interconnected in a heat sealing manner, to construct a heat dissipation unit 10 with a bag structure, and ensure that the heat dissipation unit 10 has sufficient sealing performance to prevent a liquid leakage problem.

Optionally, the protective layer 141 includes at least one of the following film layers: a PET film layer, an LLDPE film layer, a PE layer, an ONY film layer, a CPP film layer, a polypropylene (polypropylene, PP) film layer, or a thermoplastic polyurethane (Thermoplastic polyurethane, TPU) film layer.

For example, the protective layer 141 may include biaxial stretching PET, biaxial stretching PP, or biaxial stretching ONY

Optionally, a thickness of the protective layer 141 may range between 8 µm and 15 µm, for example, may be 9 µm, 10 µm, 11 µm, 12 µm, or 14 µm.

The heat sealing layer 143 has good heat sealing performance, and a melting point of the heat sealing layer 143 is lower than a melting point of the protective layer 141, to ensure that the protective layer 141 does not melt in a heat sealing processing process. The heat sealing layer 143 includes at least one of the following film layers: a low-density polyethylene (low-density polyethylene, LDPE) film layer, an LLDPE film layer, an ethylene-vinyl acetate copolymer (ethylene-vinyl acetate copolymer, EVA) film layer, a high-density polyethylene (high-density polyethylene, HDPE) film layer, or a PP film layer.

Optionally, a thickness of the protective layer 141 may range between 50 µm and 80 µm, for example, may be 55 µm, 60 µm, 65 µm, 70 µm, or 75 µm.

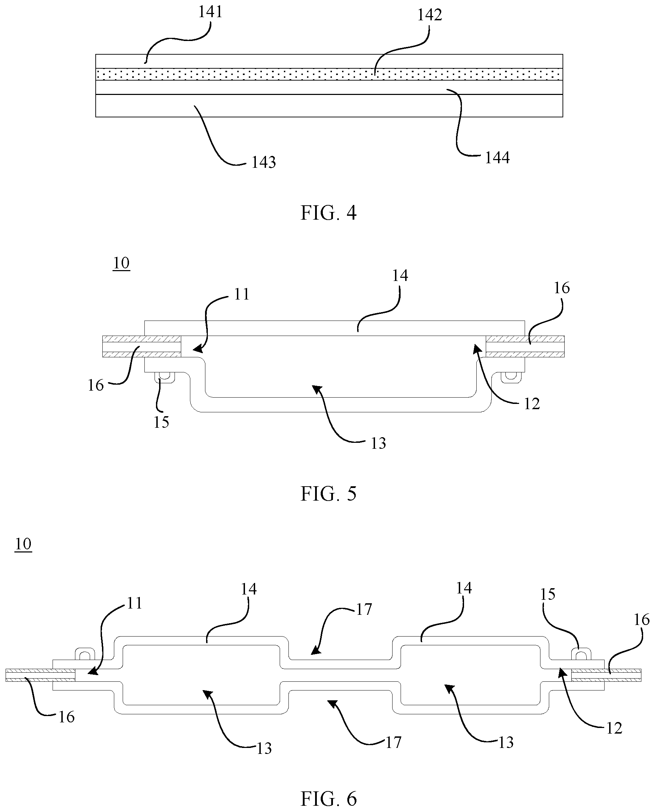

FIG. 4 is a cross-sectional view of another example of a flexible sheet material 14. Compared with the flexible sheet material 14 in the embodiment in FIG. 3, the flexible sheet material 14 provided in FIG. 4 further includes a structure enhancing layer 144, and the structure enhancing layer 144 is located between the protective layer 141 and the heat sealing layer 143.

The structure enhancing layer 144 is added, so that strength of the flexible sheet material 14 can be increased, and performance such as sealing performance, flexibility, and stiffness of the flexible sheet material 14 can be improved. The structure enhancing layer 144 may be disposed between the anti-penetration layer 142 and the heat sealing layer 143, or may be disposed between the anti-penetration layer 142 and the protective layer 141.

Optionally, the structure enhancing layer 144 may be a PET film layer, an LLDPE film layer, a PE layer, an ONY film layer, a CPP film layer, or a TPU film layer.

Optionally, a thickness of the structure enhancing layer 144 may range between 10 µm and 20 µm, for example, may be 12 µm, 15 µm, or 18 µm.

As shown in FIG. 4, appropriate combination of the foregoing four functional film layers can ensure that an overall thickness of the flexible sheet material 14 is approximately 100 µm, for example, may be 90 µm, 95 µm, 100 µm, 105 µm, 110 µm, or 112 µm. A heat transfer thermal resistance of the flexible sheet material 14 is approximately 0.2 °C/W (degree Celsius/watt), for example, 0.15 °C/W or 0.22 °C/W.

As shown in FIG. 1 and FIG. 2, the heat dissipation unit 10 has a hollow bag structure obtained by sealing and interconnecting two flexible sheet materials 14. In this case, two shaped flexible sheet materials 14 may be heat-sealed and connected by using the heat sealing layer 143, and two connected flexible sheet materials 14 form the hollow bag structure. The liquid inlet 11 and the liquid outlet 12 are reserved in the hollow bag structure. An inner cavity of the hollow bag structure forms the heat exchange cavity 13 used for storing the coolant.

Further, as shown in FIG. 1, the heat dissipation unit 10 further includes flow guiding hoses 16 disposed on the liquid inlet 11 and the liquid outlet 12. One end of the flow guiding hose 16 is inserted into the liquid inlet 11 or the liquid outlet 12, and keeps a sealed connection. The other end of the flow guiding hose 16 is configured to connect to an external circulation system, to receive a coolant or guide a coolant out. The flow guiding hose 16 is disposed, so that sealing and interconnection between the heat dissipation unit 10 and an external pipeline can be facilitated, and installation and disposing of the heat dissipation unit 10 are also facilitated. In addition, a liquid leakage problem caused by a direct connection between the external pipeline and the liquid inlet 11 or outlet 12 can also be avoided.

Optionally, in another implementation, surrounding edges of the two flexible sheet materials 14 may alternatively be sealed and connected by using a high-frequency hot-pressing welding process, an ultrasonic hot-pressing (welding) process, or the like. The flow guiding hose 16 may be disposed in the liquid inlet 11 or the liquid outlet 12 on the two sides of the heat dissipation unit 10 in a sealing manner by using the ultrasonic hot-pressing process.

As shown in FIG. 1, the heat dissipation unit 10 further includes a mounting ear 15 disposed on the flexible sheet material 14, and a through hole is provided inside the mounting ear 15. The mounting ear 15 is configured to install and position the heat dissipation unit 10, to restrict a position and a deformation range of the heat dissipation unit 10, and ensure that the heat dissipation unit 10 and the heat generation component 20 maintain relatively correct working positions, and the heat dissipation unit 10 and the heat generation component 20 can always keep close contact, to ensure efficient heat transfer.

The mounting ear has a hollow structure and has the through hole inside. During actual application, a component such as a support beam (pole) may be penetrated into the through hole to "hang" the heat dissipation unit 10, to implement installation and positioning of the mounting ear 15. There may be a plurality of heat dissipation units 10 in an entire liquid cooling cycle. In this case, one support beam may simultaneously pass through through holes of the plurality of heat dissipation units 10 that are disposed in parallel, thereby helping simplify an installation structure.

Optionally, the heat dissipation unit 10 may have one or more mounting ears 15 based on a size, a shape, and the like of the heat dissipation unit 10. For example, two, three, or four mounting ears 15 may be disposed. The plurality of mounting ears 15 may be disposed at different positions of the heat dissipation unit 10 at spacings. For example, the plurality of mounting ears 15 are disposed at two opposite ends of the heat dissipation unit 10, at least one mounting ear 15 is disposed adjacent to the liquid inlet 11, and at least one mounting ear 15 is disposed adjacent to the liquid outlet 12.

Optionally, the mounting ear 15 may be disposed on the flexible sheet material 14 in a manner such as bonding. Alternatively, the mounting ear 15 and the flexible sheet material 14 may be cut from a same sheet material to form an integrated structure, and the mounting ear 15 protrudes from an edge of the flexible sheet material 14.

FIG. 5 is a diagram of a structure of another example of a heat dissipation unit 10 according to this application. With reference to FIG. 1 and FIG. 5, it can be learned that the heat dissipation unit 10 may be constructed into a different shape and a different size, so that the heat dissipation unit 10 can be simultaneously in reliable contact with a plurality of heat generation components 20 at different positions. As shown in FIG. 1, both the two flexible sheet materials 14 may be configured into a shape in which a middle part protrudes outward (bulged outward) relative to an edge. In this case, the heat dissipation unit 10 forms a "double-side bag structure". When the coolant is injected into the heat dissipation unit 10, the flexible sheet materials 14 on the two opposite sides simultaneously expand outward, and expansion degrees are approximately the same.

As shown in FIG. 5, one of flexible sheet materials 14 may be configured into a shape in which a middle part protrudes outward relative to an edge, and the other one of heat dissipation units 10 may be configured into a flat sheet structure. In this case, the heat dissipation unit 10 forms a "single-side bag structure". When a coolant is injected into the heat dissipation unit 10, a flexible sheet material 14 on a lower side in FIG. 5 expands outward, and a flexible sheet material 14 on an upper side expands outward to a very limited extent.

FIG. 6 is a diagram of an overall structure of still another example of a heat dissipation unit 10 according to this application. As shown in FIG. 6, a shape and a structure of the heat dissipation unit 10 are adaptively adjusted based on a layout of the heat generation component 20. The heat dissipation unit 10 may has a special avoidance structure such as a special shape, a hole, or a concave structure to avoid sharp-shaped components such as a connector, a pin, and a trace on a circuit board, or avoid a position not suitable for designing the heat dissipation unit 10, and ensure that the heat dissipation unit 10 can be in full contact with the heat generation component 20.

An overall shape of the heat dissipation unit 10 may be obtained by changing a shape of a flexible sheet material 14. As shown in FIG. 6, the heat dissipation unit 10 may be configured into a "double-side bag structure". When the heat dissipation unit 10 is filled with a coolant, a middle part of the heat dissipation unit 10 is concave inward relative to two sides, that is, a width of the middle part of the heat dissipation unit 10 is narrower than a width of the two sides. In this case, the middle part of the heat dissipation unit 10 is concave, a concave space 17 is formed, and the concave space 17 can be used to accommodate the sharp-shaped components such as the connector and the pin on the circuit board. Therefore, the heat dissipation unit 10 can avoid the foregoing sharp components, and two side parts of the heat dissipation unit 10 can be separately in contact with one heat generation component 20 for heat conduction connection.

Based on a comparison between FIG. 1 and FIG. 6, the heat dissipation unit 10 shown in FIG. 6 has an overall structure with a plurality of branches and a hollow interior. For example, one heat dissipation unit 10 includes small parts of two or more branches, two adjacent branches are separated from each other by using the foregoing concave space 17, and each branch may be considered as a small heat dissipation unit 10. For example, the heat dissipation unit 10 shown in FIG. 6 may be considered to be obtained by combining and interconnecting two heat dissipation units 10 shown in FIG. 1.

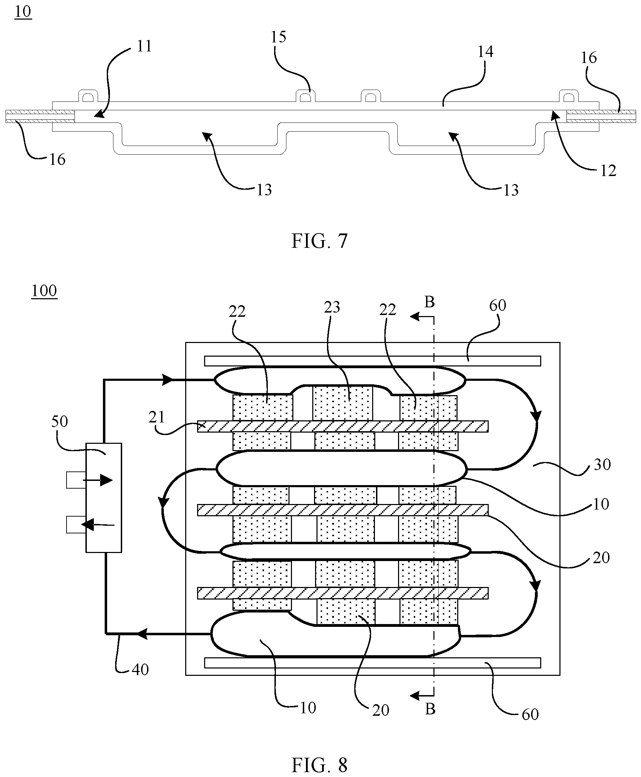

FIG. 7 is a diagram of an overall structure of yet another example of a heat dissipation unit 10 according to this application. As shown in FIG. 7, the heat dissipation unit 10 may be configured into a "single-side bag structure". The heat dissipation unit 10 shown in FIG. 7 may be considered to be obtained by combining and interconnecting two heat dissipation units 10 shown in FIG. 5. In this case, a plurality of (for example, four) mounting ears 15 may be disposed on a flat flexible sheet material 14.

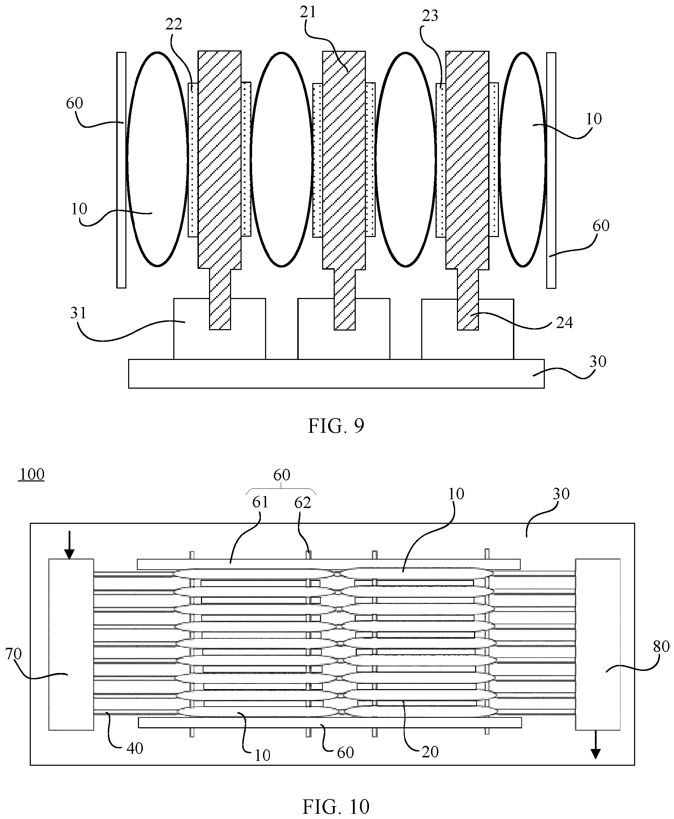

An embodiment of this application further provides a liquid cooling heat dissipation apparatus 100. FIG. 8 is a diagram of a structure of an example of the liquid cooling heat dissipation apparatus 100 according to this application. FIG. 9 is a cross-sectional view from a BB perspective in FIG. 8. As shown in FIG. 8 and FIG. 9, the liquid cooling heat dissipation apparatus 100 provided in this embodiment of this application includes a heat generation component 20 and the heat dissipation unit 10 provided in any one of the foregoing embodiments. The heat dissipation unit 10 is configured to be in contact with the heat generation component 20. Heat dissipated by the heat generation component 20 during working is conducted to the coolant in the heat exchange cavity 13 by using the flexible sheet material 14, and the coolant flows in the heat exchange cavity 13 to carry the heat dissipated by the heat generation component 20, to complete heat dissipation performed on the heat generation component 20.

Optionally, the liquid cooling heat dissipation apparatus 100 may be any device that needs liquid cooling heat dissipation, for example, may be a computer device or a network device such as a server, a switch, or a base station. For example, the liquid cooling heat dissipation apparatus 100 may be a cabinet-type server, or may be a node in a cabinet-type server.

Optionally, the heat generation component 20 may be any element that can generate heat during working and that needs liquid cooling heat dissipation processing. For example, the heat generation component 20 may be any electrical element such as a CPU, a power supply chip, a processor chip, a control chip, a functional chip, a circuit, a memory module (memory chip), or a graphics card.

Optionally, the heat dissipation unit 10 may be a part of a liquid cooling circulation system, and a coolant flowing in the sealed liquid cooling circulation system may be water (deionized water), mineral oil, silicon oil, synthetic ester oil, fluorine oil, fluoride liquid, or the like. However, this is not limited thereto.

As shown in FIG. 8 and FIG. 9, the liquid cooling heat dissipation apparatus 100 provided in this embodiment of this application further includes a circuit board 30, a circulation pipeline 40, and a pipeline interface 50. A plurality of heat generation components 20 are disposed on the circuit board 30. In this embodiment, the heat generation component 20 is a memory module, and the circuit board 30 is a mainboard. For ease of description and understanding, the heat generation component 20 is represented as a memory module 20, and the circuit board 30 is represented as a mainboard 30 below.

The circulation pipeline 40 forms a part of the liquid cooling circulation system, and is mainly configured to transfer a coolant. A plurality of heat dissipation units 10 may be disposed on the circulation pipeline 40 in parallel and/or in series, that is, the circulation pipeline 40 is configured to interconnect the plurality of heat dissipation units 10 together in parallel and/or in series. The pipeline interface 50 is connected to two end portions of the circulation pipeline 40, and has two interfaces. The two interfaces are respectively connected to an external coolant input pipeline and an external coolant output pipeline. The pipeline interface 50 can transfer, to the circulation pipeline 40, the coolant transferred by the coolant input pipeline, and the coolant flows in the circulation pipeline 40 and the heat dissipation unit 10. The plurality of heat dissipation units 10 dissipate heat for the plurality of memory modules 20, and a coolant obtained after heat exchange is output from the circulation pipeline 40 to the coolant output pipeline through the pipeline interface 50.

The pipeline interface 50 is disposed, so that a "plug-in design" of the entire liquid cooling circulation system can be implemented. After the plurality of heat dissipation units 10 are connected through the circulation pipeline 40, the heat dissipation units 10 may be first installed at an appropriate position, and then connected to an external coolant input pipe and an external coolant output pipe through the pipeline interface 50. This facilitates installation of the circulation system.

As shown in FIG. 8 and FIG. 9, N memory modules 20 (for example, three memory modules 20 in the figure) are disposed on the mainboard 30. One heat dissipation unit 10 is installed on both sides, namely, a front surface and a back surface of each memory module 20. There are N+1 heat dissipation units 10 (for example, four heat dissipation units 10 disposed in series in the figure) in total that form close heat contact with the memory modules 20. When the heat dissipation unit 10 work in the liquid cooling cycle system, a plurality of bulged working surfaces are formed, the plurality of working surfaces respectively form heat contact of a specific area with surfaces of a memory chip, a power supply chip, and a control chip on the memory module 20.

There are the N+1 heat dissipation units 10 in total that form close heat contact with the memory modules 20 on the mainboard 30. The heat dissipation unit 10 and the memory module 20 maintain relatively correct working positions. The heat dissipation unit 10 forms efficient surface contact with a heat source on the memory module 20, to form a heat transfer path. The heat dissipation unit 10 is of a bag structure, and maintains a shrinking shape in a non-working state, to ensure that the heat dissipation unit 10 is conveniently installed at a position between two adjacent memory modules 20. When the liquid cooling circulation system works, the heat dissipation unit 10 forms the plurality of bulged working surfaces under an action of liquid pressure, and the plurality of working surfaces respectively form heat contact of the specific area with the surfaces of the memory chip, the power supply chip, and the control chip on the memory module 20.

A position and a deformation range of the heat dissipation unit 10 may be restricted by using a mounting ear 15 and a limiting structure 60, to ensure that the heat dissipation unit 10 is always in close contact with the memory module 20. The limiting structure 60 may be disposed at an edge position of an array of memory modules 20, and a heat dissipation unit 10 at an edge can be reliably attached to an outer surface of the memory module 20 by using the limiting structure 60.

The limiting structure 60 is configured to perform installation limiting on the heat dissipation unit 10, and is configured as follows: When the heat dissipation unit 10 is in a working state with pressure, the heat dissipation unit 10 is in contact with the memory module 20 to form heat conduction; or when the heat dissipation unit 10 is in a non-working state without pressure, the heat dissipation unit 10 shrinks and is separated from the memory module 20.

As shown in FIG. 8 and FIG. 9, the memory module 20 includes a substrate 21, memory chips 22 and power supply chips 23 are disposed on two sides of the substrate 21, a gold finger 24 is disposed at a bottom of the substrate 21, and the gold finger 24 is configured to cooperate with a socket on the mainboard 30 in a pluggable manner, to implement installation or removal of the memory module 20.

As shown in FIG. 8, heights (thicknesses) of a memory chip 22 and a power supply chip 23 on the side surface of the substrate 21 may be different, and a shape of the heat dissipation unit 10 may be correspondingly designed, so that thicknesses at different positions that are of the heat dissipation unit 10 and that exists after the heat dissipation unit 10 is bulged are also different, and it is ensured that the heat dissipation units 10 can maintain heat contact having sufficient attaching areas with heat sources (chips) at different heights.

The heat dissipation unit 10 and the memory module 20 on the mainboard 30 in the liquid cooling heat dissipation apparatus 100 form an efficient heat conduction connection. The heat dissipation unit 10 is connected to the circulation pipeline 40 and the like, to form a closed circulation system. Heat generated when the memory module 20 works is taken away continuously through circulation of the coolant. In this way, high heat dissipation efficiency can be maintained, a small design spacing between the memory modules 20 can also be maintained, and a reliability requirement is met, which ensures that the liquid cooling heat dissipation apparatus 100 can run stably for a long time, and helps prolong a service life of the apparatus.

FIG. 10 is a diagram of a structure of another example of a liquid cooling heat dissipation apparatus 100 according to this application. As shown in FIG. 10, in this embodiment, the liquid cooling heat dissipation apparatus 100 may be a node of a cabinet-type server. The liquid cooling heat dissipation apparatus 100 includes a mainboard 30. The mainboard 30 includes two main chips (not shown in the figure) and 16 memory modules 20. The plurality of memory modules 20 are arranged in two columns and eight rows. A row spacing of the memory modules 20 is 7.6 mm. The memory chip is a DDR5 sample. A working temperature needs to be lower than 95 °C, and maximum power consumption of a single memory module 20 is 15 W. The memory module 20 and a heat dissipation unit 10 are disposed at spacings, and there are nine heat dissipation units 10 in total. Each heat dissipation unit 10 is mounted on four crossbeams 62 by using four mounting ears 15 (refer to FIG. 7) disposed on a flexible sheet material 14. The crossbeams 62 are mounted on two limiting plates 61 disposed on outermost sides of the memory modules 20 in the plurality of columns. The limiting plate 61 is disposed on the mainboard 30. A distance between the limiting plate 61 and an outermost memory module 20 is slightly less than 7.6 mm, and a function of the limiting plates 61 is to limit the nine heat dissipation units 10 and eight memory modules 20 in a specific space. Liquid loops of the nine heat dissipation units 10 are disposed in parallel, liquid inlet pipes of the plurality of heat dissipation units 10 are installed on a liquid distributor 70, a flow direction of a coolant is shown by a black arrow in FIG. 10, and liquid outlet pipes of the plurality of heat dissipation units 10 are installed on a liquid collector 80.

The parallel liquid loops of the nine heat dissipation units 10 and a liquid loop of liquid cooling plates disposed on the two main chips (not shown in the figure) on the mainboard 30 are connected in parallel, or may be connected in series. For example, the liquid cooling plate disposed on the main chip may alternatively be implemented by using the heat dissipation unit 10 provided in this application.

With reference to FIG. 7, a designed wall thickness of the heat dissipation unit 10 in this embodiment is 100 µm, a converted thermal resistance is 0.2 °C/W, a withstand voltage of extreme working pressure is less than or equal to 0.25 MPa, a length of a branch of the heat dissipation unit 10 is about 130 mm, a height of the branch is about 33 mm, and an overall length of the heat dissipation unit 10 is about 390 mm.

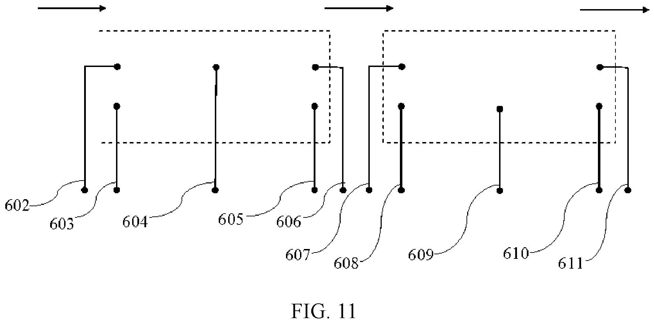

FIG. 11 is a distribution diagram of test points existing when the liquid cooling heat dissipation apparatus shown in FIG. 10 is tested. As shown in FIG. 10 and FIG. 11, the mainboard 30 includes the 16 memory modules in the eight rows and the two columns, and there are a total of nine heat dissipation units 10 disposed at spacings. 10 memory chips in two rows and five columns are disposed on each memory module 20. 10 thermocouple lines for measuring temperatures are arranged on memory modules 20 in each column, where the 10 thermocouple lines are arranged on chip surfaces of memory chips 602, 603, 607, and 608 at coolant inlets, chip surfaces of memory chips 605, 606, 610, and 611 at coolant outlets, a surface of a power supply chip 604 of the memory modules 20, and a surface of a memory chip 609 at a middle position.

Power of each memory module 20 is set to 15 W. A water temperature at the coolant inlet is 25 °C. A test flow rate ranges from 0.2 L/min to 1 L/min. The flow rate is increased by a gradient of 0.1 L/min. Readings of the 10 thermocouple lines for measuring the temperatures are recorded. A condition for stopping a test is: (1) a surface temperature of any memory chip exceeds 95 °C, or (2) the heat dissipation unit 10 is cracked. Some of recorded test data is disclosed as follows:

**Table 1: Some test data**

| | | | | | | | | |
|---|---|---|---|---|---|---|---|---|
| Power consumption | 15 W*8 pcs | | | | | | | |
| Memory specification | 95 °C | | | | | | | |
| Inlet water temperature | 45 °C | | | | | | | |
| Measured flow rate | 1000 | 889 | 802 | 706 | 589 | 506 | 402 | 307 |
| Sensor position | Average value of measured temperatures (°C) | | | | | | | |
| 602 | 55.5 | 56.6 | 56.9 | 57.0 | 57.5 | 57.5 | 57.6 | 58.3 |
| 603 | 58.6 | 60.0 | 59.9 | 60.3 | 60.5 | 60.8 | 61.3 | 62.5 |
| 604 | 80.4 | 81.0 | 82.2 | 81.0 | 82.5 | 81.4 | 82.6 | 82.5 |
| 605 | 54.2 | 60.6 | 60.8 | 61.0 | 61.2 | 61.4 | 61.4 | 62.9 |
| 606 | 55.8 | 56.7 | 56.7 | 56.9 | 56.8 | 57.3 | 57.8 | 59.3 |
| 607 | 59.2 | 60.7 | 61.0 | 61.5 | 61.9 | 62.1 | 62.0 | 62.3 |
| 608 | 57.5 | 58.9 | 59.7 | 60.0 | 60.0 | 60.2 | 59.8 | 60.3 |
| 609 | 55.8 | 56.8 | 56.8 | 56.7 | 56.6 | 56.4 | 56.0 | 56.6 |
| 610 | 58.0 | 61.6 | 62.3 | 62.5 | 62.6 | 62.7 | 63.0 | 65.4 |
| 611 | 60.1 | 61.5 | 61.7 | 61.6 | 61.5 | 61.4 | 61.2 | 62.1 |
| Highest temperature | 63.5 | 64.3 | 65.0 | 64.5 | 65.7 | 65.0 | 65.5 | 65.8 |

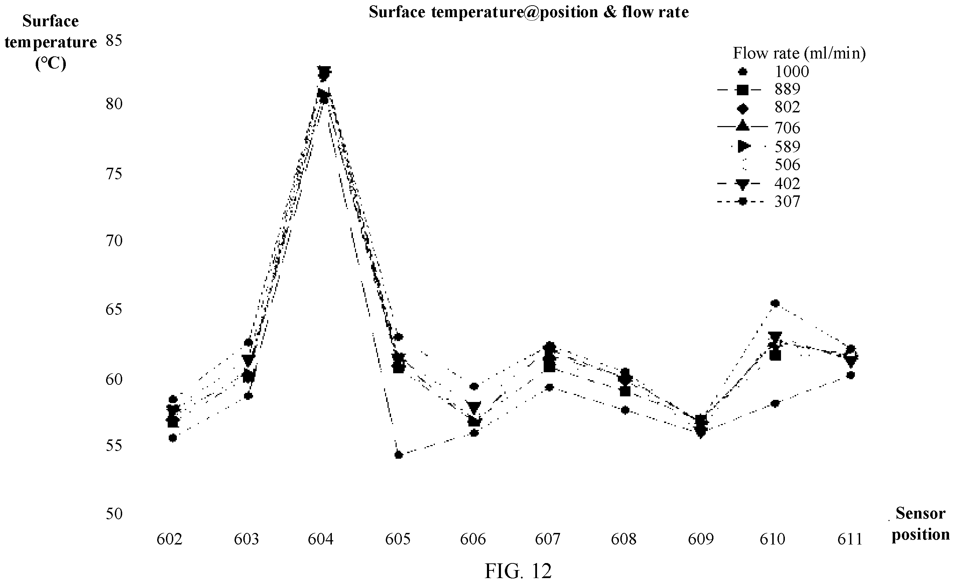

FIG. 12 is a temperature distribution diagram of each test point shown in FIG. 11. With reference to Table 1 and FIG. 12, the following conclusions may be obtained.
(1) The surface temperature of the memory chip is decreased as the liquid cooling flow rate is increased. However, when the flow rate ranges between 400 ml/min and 900 ml/min, effect that the temperature is decreased as the flow rate is increased is not obvious. When the flow rate is 300 ml/min, the surface temperature of the memory chip is obviously high. When the flow rate reaches 1000 ml/min, a cooling temperature of a surface of the memory chip is also significantly different (low).
(2) A temperature of a test point 604 is obviously high. This test position is on the power supply chip instead of on the memory chip, and is merely used as a reference.
(3) Temperature measurement points on surfaces of all memory chips in all test flow rate series are all lower than 65 °C, heat dissipation performance of the heat dissipation unit 10 is good, and a heat dissipation problem of the liquid cooling heat dissipation apparatus 100 is effectively resolved.
(4) A surface temperature of a memory chip at a coolant inlet is slightly lower than a surface temperature of a memory chip at a same position at an outlet. However, a difference is not obvious, and is related to a structure of the heat dissipation unit 10 and a flow path of the coolant.

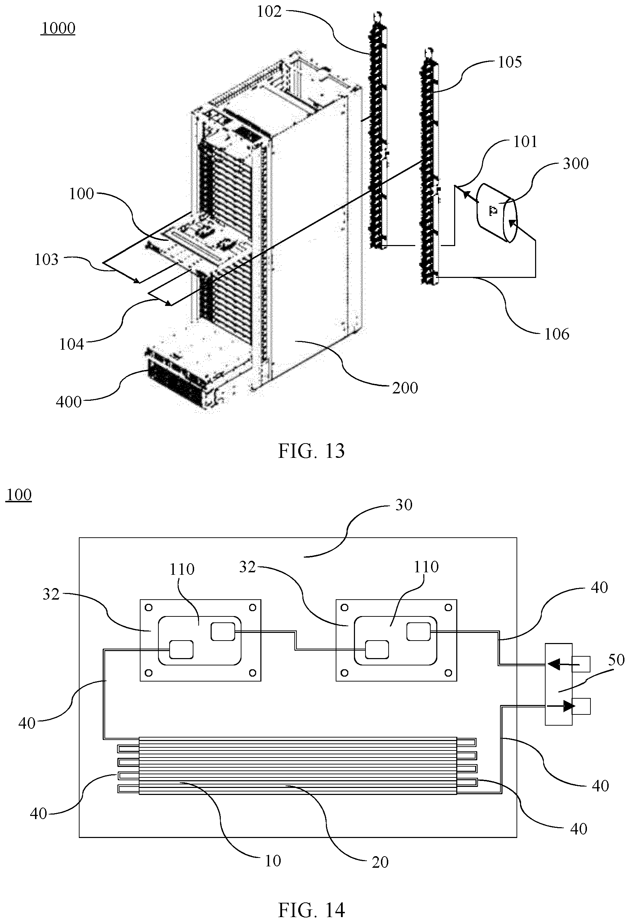

An embodiment of this application further provides a cabinet-type server 1000. FIG. 13 is an exploded diagram of a structure of the cabinet-type server 1000 according to an embodiment of this application.

As shown in FIG. 13, the cabinet-type server 1000 includes a cabinet 200, a liquid circulation system 300, and the liquid cooling heat dissipation apparatus 100 provided in any one of the foregoing embodiments. There are a plurality of liquid cooling heat dissipation apparatuses 100. The plurality of liquid cooling heat dissipation apparatuses 100 form a plurality of nodes of the cabinet-type server 1000, and are accommodated in the cabinet 200. As a subrack unit, the liquid cooling heat dissipation apparatus 100 is movably (pullably) disposed in the cabinet 200. When the liquid cooling heat dissipation apparatus 100 needs to be maintained, the liquid cooling heat dissipation apparatus 100 may be pulled out from the cabinet 200.

The liquid circulation system 300 is accommodated in the cabinet 200, and is configured to: provide a coolant for the liquid cooling heat dissipation apparatus 100, and lead out a coolant obtained after heat exchange. Specifically, a cabinet water inlet pipe 101 feeds cold water provided by the liquid circulation system 300 into a liquid distribution pipe 102. After being distributed by the liquid distribution pipe 102, cold water enters each liquid cooling heat dissipation apparatus 100 in the cabinet 200 through a node liquid inlet pipe 103, absorbs heat generated by the liquid cooling heat dissipation apparatus 100, passes through a node liquid outlet pipe 104, and flows back to the liquid circulation system 300 through a liquid collection pipe 105. Cold water circulates in the cabinet 200 continuously to take away heat from the cabinet 200.

As shown in FIG. 13, a battery subrack 400 is further disposed at a bottom of the cabinet 200, and the battery subrack 400 is configured to provide electric energy for electrical components in the entire cabinet 200, to ensure that the server can run normally.

FIG. 14 is a diagram of a structure of the liquid cooling heat dissipation apparatus 100 in FIG. 13. As shown in FIG. 14, each liquid cooling heat dissipation apparatus 100 includes at least one mainboard 30. For example, two main chips 32 are disposed on the mainboard 30, and one liquid cooling plate 110 is disposed on each of the two main chips 32. For example, eight memory modules 20 are further disposed on the mainboard 30, and nine heat dissipation units 10 provided in this application are disposed between the eight memory modules 20. A liquid inlet and a liquid outlet of each heat dissipation unit 10 are connected in series. Two liquid cooling plates 110 and the nine heat dissipation units 10 are connected in series through a circulation pipeline 40, to form a liquid cooling circulation pipeline. The node liquid inlet pipe 103 inputs an external coolant into the circulation pipeline 40 through a pipeline interface 50. The circulating coolant carries heat generated when the main chips 32 and the memory modules 20 work, and flows to the node liquid outlet pipe 104 through the other interface of the pipeline interface 50. Then, a coolant obtained after heat exchange passes through the liquid collection pipe 105 to return to the liquid circulation system 300, and finally a closed circulation loop is formed.

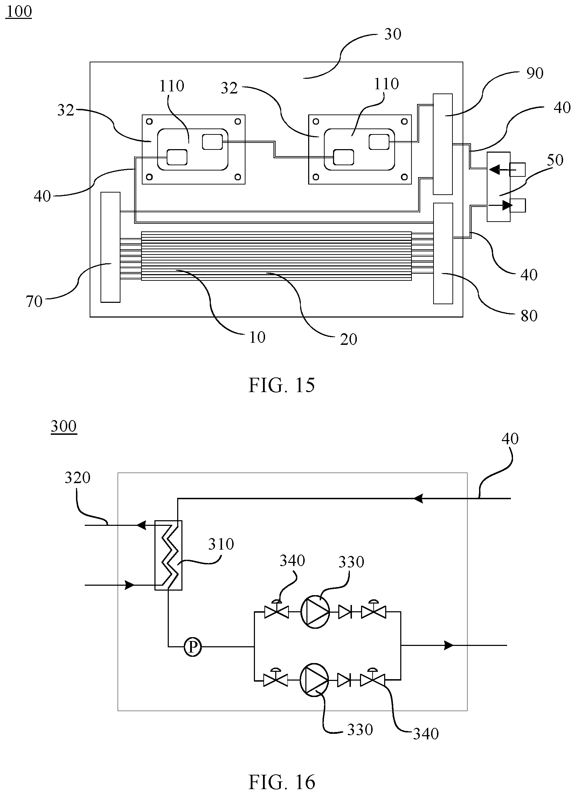

In another implementation, the plurality of liquid cooling plates 110 and the heat dissipation units 10 in the liquid cooling heat dissipation apparatus 100 may alternatively be connected in a plurality of manners, for example, connected in parallel or connected in series and in parallel, to form a closed liquid circulation pipeline. FIG. 15 is a diagram of an overall structure of another example of the liquid cooling heat dissipation apparatus 100 in FIG. 13. As shown in FIG. 15, two liquid cooling plates 110 that dissipate heat for two main chips 32 are connected through a series liquid loop, nine heat dissipation units 10 are disposed between eight memory modules 20, and are connected through parallel liquid loops. Inlets of the plurality of parallel liquid loops are connected to a liquid distributor 70, and a plurality of outlets of the parallel liquid loops are connected to a liquid collector 80. A liquid cooling loop of the main chips 32 and liquid loops of the memory modules 20 are connected in parallel through a liquid distributor 90 and the liquid collector 80, and are connected to the liquid circulation system 300 through two interfaces of the pipeline interface 50.

FIG. 16 is a diagram of an overall structure of the liquid circulation system 300 in FIG. 13. As shown in FIG. 16, the liquid circulation system 300 may be a chilled water distribution unit (chilled water distribution unit, CDU), and the CDU is an apparatus that implements heat exchange between two different water paths and provides driving for circulating water in the cabinet. The CDU generally includes a heat exchanger and a water pump. The heat exchanger exchanges heat of internal and external circulating water to a circulation cooling water system in an equipment room. The liquid cooling pump provides a driving force for circulation of a liquid cooling medium in the cabinet. Heat generated by the nodes is exchanged to the circulation cooling water system in the equipment room by using the heat exchanger.

As shown in FIG. 16, the liquid circulation system 300 includes a heat exchanger 310. An external circulation water pipe 320 guides circulation cooling water in the equipment room to the heat exchanger 310. The circulation pipeline 40 guides a coolant in the circulation loop to the heat exchanger 310. Heat exchange between the circulation cooling water in the equipment room and the coolant is completed in the heat exchanger 310, that is, the circulation cooling water in the equipment room takes away heat of the coolant. A cooled coolant is circulated again to the liquid cooling heat dissipation apparatus 100 for heat exchange. A plurality of liquid cooling pumps 330 are further disposed on the circulation pipeline 40 to provide circulation power. The plurality of liquid cooling pumps 330 are disposed in parallel. At least one solenoid valve 340 is disposed on each branch connected in parallel, so that each branch can be separately controlled.

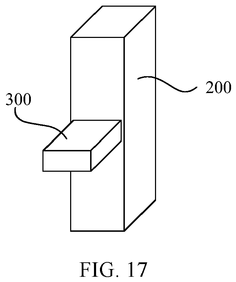

FIG. 17 is a diagram of installation of the liquid circulation system 300. As shown in FIG. 17, the liquid circulation system 300 provided in this embodiment of this application may be of a standard 19-inch rack structure, and may be installed in a standard 19-inch cabinet 200, so that an internal space of the cabinet 200 is fully utilized.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A flexible liquid cooling heat dissipation unit (10), wherein the flexible liquid cooling heat dissipation unit (10) is configured to dissipate heat for a heat generation component (20), a liquid inlet (11) and a liquid outlet (12) are provided on the flexible liquid cooling heat dissipation unit (10), and a heat exchange cavity (13) that is used for accommodating a coolant and allowing the coolant to flow from the liquid inlet (11) to the liquid outlet (12) is provided in the flexible liquid cooling heat dissipation unit (10); and
the liquid cooling heat dissipation unit (10) comprises a flexible sheet material (14), wherein the flexible sheet material (14) is obtained by compounding a plurality of functional film layers, the plurality of functional film layers comprise at least one anti-penetration layer (142), and permeability of the anti-penetration layer (142) is less than 1 g/m²/24hr.

2. The flexible liquid cooling heat dissipation unit (10) according to claim 1, wherein the plurality of functional film layers further comprise a protective layer (141) and a heat sealing layer (143), the anti-penetration layer (142) is located between the protective layer (141) and the heat sealing layer (143), and the protective layer (141) forms an outer surface of the flexible liquid cooling heat dissipation unit (10).

3. The flexible liquid cooling heat dissipation unit (10) according to claim 2, wherein the plurality of functional film layers further comprise a structure enhancing layer (144), and the structure enhancing layer (144) is located between the protective layer (141) and the heat sealing layer (143).

4. The flexible liquid cooling heat dissipation unit (10) according to any one of claims 1 to 3, wherein the anti-penetration layer (142) comprises at least one of the following film layers:
an ethylene vinyl alcohol copolymer film layer, a polyvinylidene chloride film layer, an o-phenylphenol film layer, an aluminum-cast polypropylene film layer, a polyethylene film layer, a polyethylene glycol terephthalate film layer, a cast polypropylene film layer, a linear low-density polyethylene film layer, a cellulose propionate film layer, a polyamide film layer, or a metal film layer.

5. The flexible liquid cooling heat dissipation unit (10) according to any one of claims 1 to 3, wherein the anti-penetration layer (142) comprises a metal foil layer or a metal vapor deposition layer.

6. The flexible liquid cooling heat dissipation unit (10) according to claim 2 or 3, wherein the heat sealing layer (143) comprises at least one of the following film layers:
a low-density polyethylene film layer, a linear low-density polyethylene film layer, an ethylene-vinyl acetate copolymer layer, a high-density polyethylene film layer, or a polypropylene film layer.

7. The flexible liquid cooling heat dissipation unit (10) according to claim 2, 3, or 6, wherein the protective layer (141) comprises at least one of the following film layers:
a polyethylene glycol terephthalate film layer, a linear low-density polyethylene film layer, a polyethylene layer, a polyamide film layer, a cast polypropylene film layer, or a thermoplastic polyurethane film layer.

8. The flexible liquid cooling heat dissipation unit (10) according to any one of claims 1 to 7, wherein the liquid cooling heat dissipation unit (10) has a hollow bag structure obtained by sealing and interconnecting two flexible sheet materials (14).

9. The flexible liquid cooling heat dissipation unit (10) according to any one of claims 1 to 8, wherein the flexible liquid cooling heat dissipation unit (10) further comprises a mounting ear (15) disposed on the flexible sheet material (11), and a through hole is provided inside the mounting ear (15).

10. The flexible liquid cooling heat dissipation unit (10) according to any one of claims 1 to 9, wherein the flexible liquid cooling heat dissipation unit (10) further comprises flow guiding hoses (16) disposed on the liquid inlet (11) and the liquid outlet (12).

11. The flexible liquid cooling heat dissipation unit (10) according to any one of claims 1 to 10, wherein the heat generation component (20) is a memory module, and the flexible liquid cooling heat dissipation unit (10) is configured to be disposed between two memory modules.

12. A liquid cooling heat dissipation apparatus (100), comprising:
a heat generation component (20); and
the flexible liquid cooling heat dissipation unit (10) according to any one of claims 1 to 11, wherein the flexible liquid cooling heat dissipation unit (10) is configured to: be in contact with the heat generation component (20), and dissipate heat for the heat generation component (20) by using a coolant flowing in the heat exchange cavity (13).

13. The liquid cooling heat dissipation apparatus (100) according to claim 12, wherein the liquid cooling heat dissipation apparatus (100) further comprises:
a circuit board (30), wherein a plurality of heat generation components (20) are disposed on the circuit board (30);
a circulation pipeline (40), configured to interconnect a plurality of flexible liquid cooling heat dissipation units (10) in parallel and/or in series, wherein the plurality of flexible liquid cooling heat dissipation units (10) dissipate heat for the plurality of heat generation components (20); and
a pipeline interface (50), configured to be connected to an external pipeline, to transfer a coolant to the circulation pipeline (40), and discharge, from the circulation pipeline (40), a coolant obtained after heat exchange.

14. The liquid cooling heat dissipation apparatus (100) according to claim 12 or 13, wherein the heat generation component (20) is a memory module, and the flexible liquid cooling heat dissipation unit (10) is disposed between two memory modules.

15. An electronic device, comprising the liquid cooling heat dissipation apparatus according to any one of claims 12 to 14.
